# DEMANDE DE BREVET EUROPEEN

(11) **EP 4 160 910 A1**
(43) Date de publication de la demande: **05.04.2023**
(21) Numéro de dépôt: 21200071.5
(22) Date de dépôt: 30.09.2021
(51) Int. Cl.: H03D 11/04, H03D 11/08, H03B 5/12

(54) **PROCEDE DE DETECTION D'UN SIGNAL RF DANS UN RECEPTEUR A SUPER REACTION, ET RECEPTEUR POUR LA MISE EN 0EUVRE DU PROCEDE**

(71) Demandeur: The Swatch Group Research and Development Ltd, 2074 Marin (CH)
(72) Inventeur: CASAGRANDE, Arnaud, 2014 Bôle (CH); AREND, Jean-Luc, 2035 Corcelles (CH)
(74) Mandataire: ICB SA

(57) **Abrégé**

Il est prévu un procédé de détection d'un signal RF capté par un récepteur (1) à super réaction. Le récepteur comprend un oscillateur de référence (4) pour la génération d'une oscillation dans l'oscillateur, un générateur de courant de polarisation (7) pour l'oscillateur pour fournir un courant de polarisation dès la réception d'un signal de commande de début d'oscillation (start), un détecteur d'oscillation (6) connecté entre une sortie (coilp) de l'oscillateur et le générateur de courant de polarisation pour le commander quand un signal RF est reçu par le récepteur, et une unité d'adaptation d'impédances (3) disposée entre l'entrée du récepteur et l'oscillateur de référence (4). Suite à l'activation d'un signal de commande de début d'oscillation, une détection de l'oscillation de l'oscillateur de référence est effectuée, et dès que l'oscillateur de référence oscille au-dessus d'une valeur critique de courant de polarisation croissant, le détecteur d'oscillation commande le générateur de courant de polarisation pour couper immédiatement le courant de polarisation et arrêter ainsi l'oscillation de l'oscillateur de référence dans le but de réduire la consommation électrique générale lors de la phase de détection d'un signal RF.

## Description

### DOMAINE TECHNIQUE DE L'INVENTION

L'invention concerne un procédé de détection d'un signal RF dans un récepteur à super réaction dans le but de réduire la consommation électrique, ainsi que le récepteur pour la mise en œuvre du procédé.

### ETAT DE LA TECHNIQUE

Il est connu depuis les années 1920 et inventé par Edwin Howard Armstrong, un récepteur à ondes courtes, qui comprend également initialement trois lampes, qui coûtent cher et son invention a permis de réduire le fonctionnement du récepteur à une lampe. Comme discuté par la suite, ce principe est repris par la présente invention du récepteur à super réaction pour réduire la consommation électrique et simplifier l'architecture dudit récepteur.

La demande de brevet US 5,613,231 A décrit un oscillateur muni d'un composant actif ou amplificateur et un composant réactif de stabilisation. Le composant actif est un transistor bipolaire disposé dans un circuit à base commune, alors que le composant réactif est un résonateur diélectrique entièrement couplé au collecteur du transistor. La base du transistor bipolaire est connectée à un pôle d'une alimentation par l'intermédiaire d'une première résistance et à un point commun par l'intermédiaire d'une seconde résistance et dont l'émetteur est connecté au même pôle par une troisième résistance. Un noyau résonateur est connecté entre le collecteur du transistor bipolaire et le point commun. Rien n'est décrit concernant la manière de détecter rapidement un signal RF et dans le but de réduire la consommation électrique.

### RESUMÉ DE L'INVENTION

L'invention a donc pour but de fournir un procédé de détection d'un signal RF dans un récepteur à super réaction en palliant les inconvénients susmentionnés de l'état de la technique de manière à réduire la consommation électrique en détectant rapidement la présence d'un signal RF en entrée du récepteur. De plus, le récepteur est à même de mettre en œuvre le procédé de détection d'un signal RF.

A cet effet, l'invention concerne un procédé de détection d'un signal RF dans un récepteur à super réaction, qui comprend les caractéristiques définies dans la revendication indépendante 1.

Des étapes particulières du procédé sont définies dans les revendications dépendantes 2 à 5.

Un avantage du procédé de détection d'un signal RF dans un récepteur à super réaction réside dans le fait qu'il permet de rapidement détecter un signal RF à l'entrée du récepteur tout en réduisant la consommation électrique au maximum en ne laissant que momentanément l'oscillation de l'oscillateur de référence défini comme VCO pour la détection et en l'arrêtant dès la détection du signal RF. Selon la présente invention il est préconisé d'arrêter immédiatement l'oscillation du VCO dès qu'une détection du signal RF est déterminée. Ainsi, dès que l'oscillation apparaît ou est détectée dans l'oscillateur VCO, l'oscillation est immédiatement arrêtée pour réduire la consommation électrique. Pour ce faire, le courant moyen de polarisation de l'oscillateur VCO, qui est de préférence un oscillateur LC composé principalement d'une inductance et d'un condensateur en parallèle, doit être au niveau de la valeur du courant critique.

Avantageusement, le signal RF externe, qui est collecté par l'antenne du récepteur, est directement amené sur le circuit résonant de l'oscillateur, créant ainsi une condition d'oscillation initiale plus ou moins favorable au démarrage plus ou moins rapide de l'oscillateur.

A cet effet, l'invention concerne un récepteur à super réaction pour la mise en œuvre du procédé, qui comprend les caractéristiques définies dans la revendication indépendante 6.

Des formes particulières du récepteur sont définies dans les revendications dépendantes 7 et 8.

### BRÈVE DESCRIPTION DES FIGURES

Les buts, avantages et caractéristiques du procédé de détection d'un signal RF dans un récepteur à super réaction apparaîtront mieux dans la description suivante sur la base de formes d'exécution non limitatives et illustrées par les dessins sur lesquels :

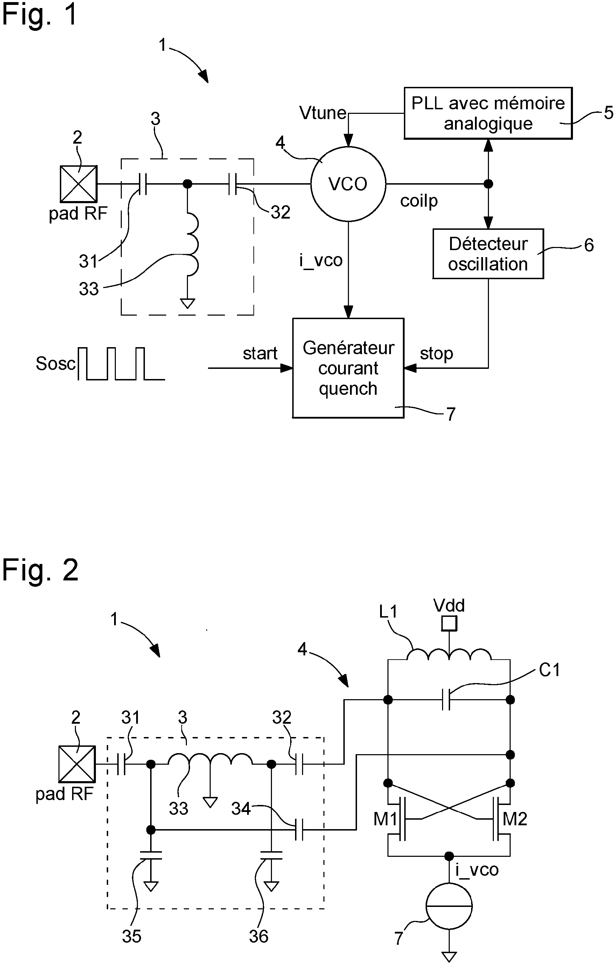

- la figure 1 représente de manière simplifiée une première forme d'exécution d'un récepteur à super réaction avec un ensemble de composants électroniques pour détecter la présence d'un signal RF à l'entrée et avec une réduction de consommation électrique selon la présente invention,
- la figure 2 représente une seconde forme d'exécution simplifiée du récepteur de signaux RF avec une unité d'adaptation d'impédances et un oscillateur de référence, tel qu'un VCO adapté en tension et avec un courant de polarisation pour la génération d'une oscillation de l'oscillateur selon la présente invention,

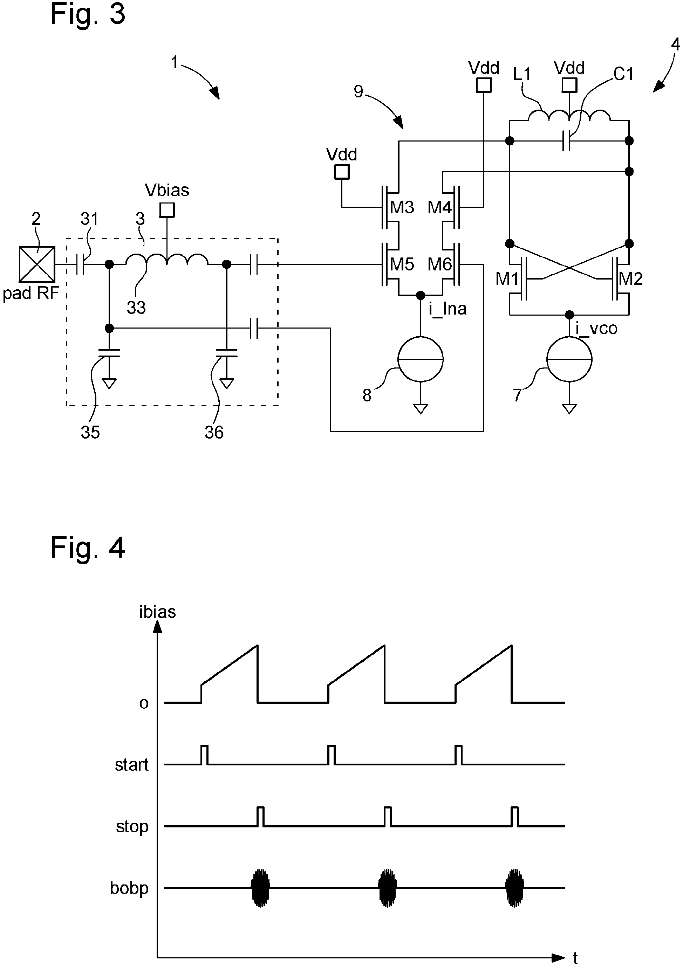

- la figure 3 représente une troisième forme d'exécution simplifiée du récepteur de signaux RF avec une unité d'adaptation d'impédances liée à un préamplificateur fournissant des signaux pré-amplifiés à l'oscillateur de référence VCO et avec des courants de polarisation pour le VCO, et
- la figure 4 représente des signaux d'activation du récepteur et principalement de l'oscillateur VCO, il est représenté principalement les signaux de départ pour l'activation de l'oscillation, les signaux de polarisation, les signaux d'arrêt suite à la détection de l'oscillation au-dessus d'un seuil critique, et coupure de l'oscillation dès sa détection définissant la présence d'un signal RF en entrée du récepteur selon la présente invention.

### DESCRIPTION DETAILLEE DE L'INVENTION

Dans la description suivante, il est fait référence à un procédé de détection d'un signal radiofréquence RF dans un récepteur à super réaction dans le but de réduire la consommation électrique pour effectuer ces opérations. Bien entendu tous les composants utilisés dans le récepteur, qui sont bien connus dans le domaine technique, ne seront relatés que de manière simplifiée. Il est fait principalement référence à la détection du signal RF en sortie de l'oscillateur de référence qui peut être un oscillateur VCO par exemple de type LC.

La figure 1 représente de manière plus complète une première forme d'exécution d'un récepteur 1 de signaux RF et susceptible de détecter la réception d'au moins un signal RF. Pour ce faire, le récepteur 1 comprend tout d'abord une borne ou pad 2 d'entrée de réception d'un signal RF. Le récepteur 1 comprend un oscillateur de référence 4 pour la génération d'une oscillation dans l'oscillateur, un générateur de courant de polarisation 7 pour fournir un courant de polarisation i_vco à l'oscillateur de référence 4. Le courant de polarisation i_vco est fourni à l'oscillateur de référence 4 notamment suite à la réception d'au moins un signal de commande d'activation ou de début start par exemple d'un cycle de signaux de commande Sosc pour le générateur de courant de polarisation 7. Le récepteur à super réaction 1 comprend encore un détecteur d'oscillation 6, qui est connecté entre une sortie coilp de l'oscillateur de référence 4 et le générateur de courant de polarisation 7 de manière à commander le générateur 7 après qu'un signal RF est reçu par le récepteur 1. Une unité d'adaptation d'impédances 3 du récepteur 1 est disposée entre la borne ou pad 2 de réception du récepteur 1 et l'oscillateur de référence 4.

Dans le cycle des signaux de commande Sosc, il y a tout d'abord un premier signal de commande start pour la fourniture d'une commande de polarisation de l'oscillateur de référence 4. Dès cet instant, suite au signal de commande d'activation start du générateur de courant de polarisation 7, le courant de polarisation croît par exemple linéairement jusqu'à obtenir une valeur critique du courant de polarisation à partir de laquelle l'oscillateur de référence 4 peut commencer à osciller par exemple à une haute fréquence de l'ordre de 2,4 GHz. Dès cet instant d'oscillation de l'oscillateur de référence 4, une détection est effectuée dans le détecteur d'oscillation 6 de manière à fournir un signal d'arrêt stop au générateur de courant de polarisation 7 pour arrêter immédiatement l'oscillation de l'oscillateur de référence 4. C'est le but recherché par la présente invention, d'arrêter ainsi complètement la fourniture du courant de polarisation fournie à l'oscillateur de référence 4 dès la détection de l'oscillation de l'oscillateur de référence 4. Une réduction de consommation électrique est ainsi obtenue en arrêtant immédiatement la fourniture du courant de polarisation i_vco à l'oscillateur 4 une fois que la valeur critique de courant de polarisation est atteinte. L'oscillateur s'arrête immédiatement d'osciller après la commande d'arrêt stop fournie par le détecteur d'oscillation 6 au générateur de courant de polarisation 7.

De préférence, l'oscillateur de référence 4 est un oscillateur VCO commandé en tension du type LC, qui comprend en parallèle au moins une inductance L1 et un condensateur C1. Dans la configuration présentée à la figure 1, l'inductance L1 est séparée en deux inductances liées l'une à l'autre et dont la liaison des deux parties d'inductance est alimentée par une tension d'adaptation Vtune. Pour ce faire, le récepteur 1 comprend encore une boucle à verrouillage de phase PLL 5 reliée entre la sortie coilp de l'oscillateur VCO 4 et un dispositif à capacité variable connecté en parallèle du circuit oscillant composé de L1. La tension d'adaptation Vtune en sortie de la boucle PLL 5 est une tension de commande de la fréquence d'oscillation de l'oscillateur VCO commandé en tension 4. La boucle PLL 5 peut comprendre une mémoire analogique pour enregistrer la tension de contrôle Vtune. Bien entendu, comme l'oscillateur agit en différentiel, il peut aussi être utilisé la borne de sortie non représentée coiln en lieu et place de la borne de sortie coilp de l'oscillateur de référence 4. Dans ce cas de figure, la borne coiln est l'entrée de l'oscillateur de référence 4 reliée par l'unité d'adaptation d'impédances 3 à la borne ou pad 2 du récepteur 1 de signaux RF.

Comme représenté à figure 1, l'unité d'adaptation d'impédances 3 permet d'adapter le signal radiofréquence RF reçu par le récepteur 1 avant d'entrer dans l'oscillateur de référence 4 qui est de préférence un oscillateur VCO. Cette unité d'adaptation d'impédances 3 comprend tout d'abord un premier condensateur 31 relié d'une part à la borne ou pad 2 d'entrée du signal RF et d'autre part relié à un second condensateur 32 dont l'autre extrémité est reliée à l'entrée de l'oscillateur de référence 4 qui est l'oscillateur VCO. L'unité d'adaptation d'impédances 3 comprend encore une inductance 33, qui est d'une part reliée à la liaison des deux condensateurs 31, 32 et d'autre part à la masse.

Bien entendu pour le récepteur à super réaction 1, il doit être prévu dans le récepteur une unité de traitement de tous les signaux, qui peut comprendre un processeur cadencé par un autre oscillateur ou un microprocesseur. Des signaux de contrôle des différents composants électroniques du récepteur peuvent être transmis par l'unité de traitement non représentée. L'unité de traitement peut prendre en compte la réception d'un premier signal RF pour commander l'activation du générateur de courant de polarisation. L'unité de traitement peut servir également à la fourniture d'au moins un signal de commande d'activation Sosc pour activer le générateur de courant de polarisation 7 dès qu'une mesure de l'activité RF est commandée.

Pour pouvoir décrire le procédé de détection d'un signal RF à l'entrée du récepteur 1, il est fait également référence à la figure 4 représentant les différents signaux pour l'opération de détection de réception du signal RF. Il est précisé également que le récepteur à super réaction 1 est de préférence un récepteur de réveil (wake-up récepteur), qui doit être en fonction continuellement mais par périodes très courtes dans le temps comme défini dans le cycle des signaux de commande Sosc, qui sont plusieurs signaux de commande successifs de début start fournis dans le temps au générateur de courant de polarisation 7. Dans le cas d'un oscillateur VCO qui est du type LC, c'est l'oscillateur, qui est prévu pour être souvent dans un état déclenché et qui est agencé pour démarrer très souvent sur de courtes périodes et très rapidement à fonctionnement à haute fréquence par exemple à 2,4 GHz. On peut enclencher rapidement l'oscillateur VCO sur de courtes périodes pour réagir avec peu de composants sur des éléments clés de l'oscillation qui doit être rapidement débutée. Il est possible que le signal de commande de début start ou l'oscillation démarre sur une période de 1 µs et que sur une seconde il y a à peu près 1000 périodes de commande de début start ou d'enclenchement de l'oscillateur VCO 4. Cela signifie que le récepteur 1 n'est enclenché totalement que pendant 1 ms sur une seconde, ce qui réduit fortement la consommation électrique et ce qui est recherché. Comme expliqué auparavant suite à un premier signal de commande de départ start fourni au générateur de courant de polarisation 7, une croissance linéaire de la valeur du courant de polarisation intervient jusqu'à atteindre une valeur critique du courant de polarisation. Dès que le courant de valeur critique est atteint, l'oscillateur de référence VCO 4 commence à osciller, ce qui est directement détecté par le détecteur d'oscillation 6 qui transmet un signal de commande d'arrêt stop d'oscillation au générateur de courant de polarisation 7. L'oscillation de l'oscillateur de référence VCO est annulée. L'information quant au signal RF détecté est présente dans le temps de démarrage uniquement. Ce temps étant établi par le démarrage de l'oscillation, il est donc possible d'éteindre alors l'oscillateur complètement, ce qui permet une réduction significative de consommation électrique du récepteur 1 par rapport à ce qui est connu dans l'état de la technique.

Bien entendu, la fréquence d'apparition de ces signaux de commande Sosc de début start pour le générateur de courant de polarisation 7, peut être modifié manuellement ou de manière automatique pour s'adapter aux conditions de l'oscillateur de référence 4.

Il est encore à noter dans un mode de centrage initial de fréquence, que l'oscillateur VCO est démarré dans une boucle de type PLL afin de déterminer la tension Vtune correspondant à la fréquence de réception notamment dans un synthétiseur de fréquences traditionnel. Ensuite, la tension est mémorisée par un DAC et le synthétiseur est désactivé. L'oscillateur VCO 4 est éteint et le signal RF peut être envoyé sur la sortie de l'oscillateur VCO 4 afin de procéder à la démodulation par super réaction (mesure du temps de démarrage du VCO en présence d'une rampe de son courant de polarisation. Ainsi, il est possible de ne pas abaisser la fréquence pour la démodulation dans ce récepteur à super réaction.

Un tel synthétiseur de fréquence, qui comprend l'oscillateur VCO, a été décrit dans la demande de brevet EP 3 573 241 A1 en référence à la figure 4 dans la description. Si un tel synthétiseur de fréquences est utilisé pour le centrage de fréquences de l'oscillateur VCO de la présente invention, cette demande de brevet est incorporée ici par référence.

Le récepteur à super réaction sera encore décrit maintenant en référence aux figures 2 et 3 d'autres formes d'exécution.

La figure 2 représente une seconde forme d'exécution du récepteur en ne montrant que l'entrée 2 du récepteur, l'unité d'adaptation d'impédances 3 et l'oscillateur de référence 4 qui est ici un oscillateur VCO 4. Sur cette figure 2, il n'est pas représenté le détecteur d'oscillation et la boucle à verrouillage de phase PLL, mais comme auparavant, ils agissent à un même endroit du récepteur. L'oscillateur VCO est composé d'une première inductance L1 et d'un condensateur C1 relié en parallèle à l'inductance L1. Comme précédemment, l'inductance L1 est séparée en deux inductances liées l'une à l'autre et dont la liaison des deux parties d'inductance est alimentée par une tension d'alimentation Vdd. L'oscillateur VCO 4 comprend encore en dessous à une première extrémité de liaison de l'inductance L1 et du condensateur C1, un premier transistor M1, qui est de préférence un transistor MOS, par exemple dans cette configuration un transistor NMOS, et à une seconde extrémité de liaison de l'inductance L1 et du condensateur C1, un second transistor M2 du même type que le premier transistor, par exemple un transistor NMOS. La borne de drain du premier transistor M1 est reliée à la première extrémité de liaison de l'inductance L1 et du condensateur C1, alors que la borne de drain du second transistor M2 est reliée à la seconde extrémité de liaison de l'inductance L1 et du condensateur C1. La grille du premier transistor M1 est reliée au drain du second transistor M2, alors que la grille du second transistor M2 est reliée au drain du premier transistor M1. Les deux sources des deux transistors M1 et M2 sont reliées pour recevoir le courant de polarisation du générateur de courant de polarisation 7. La sortie coilp de l'oscillateur VCO peut être fourni par le drain du second transistor M2.

L'unité d'adaptation d'impédances 3 comprend un premier condensateur 31 relié d'un premier côté à la borne ou pad 2 d'entrée du récepteur 1, alors qu'un second côté du premier condensateur 31 est relié à une première extrémité d'une inductance additionnelle 33, dont une seconde extrémité de l'inductance additionnelle est reliée à un premier côté d'un second condensateur 32. L'inductance additionnelle 33 est séparée en deux inductances liées l'une à l'autre et dont la liaison des deux parties d'inductance peut être reliée à la masse. La liaison du premier condensateur 31 et de l'inductance additionnelle 33 est encore reliée à un premier côté d'un troisième condensateur 34 et à un premier côté d'un quatrième condensateur 35 dont le second côté est relié à la masse. Un premier côté d'un cinquième condensateur 36 est relié à la liaison du second condensateur 32 et de l'inductance additionnelle 33. Le second côté du cinquième condensateur 36 est relié à la masse.

Un second côté du second condensateur 32 est relié à la première extrémité de l'inductance L1 et du condensateur C1 et également à la grille du second transistor M2 et au drain du premier transistor M1. Un second côté du troisième condensateur 34 est relié à la seconde extrémité de l'inductance L1 et du condensateur C1 et égalementà la grille du premier transistor M1 et au drain du second transistor M2. La tension d'adaptation de fréquence est appliquée à une capacité variable varicap connectée en parallèle de l'inductance L1.

La figure 3 représente une troisième forme d'exécution du récepteur 1 en ne montrant que l'entrée 2 du récepteur, l'unité d'adaptation d'impédances 3, l'oscillateur de référence 4 qui est ici un oscillateur VCO 4, ainsi qu'un préamplificateur 9 disposé entre l'unité adaptation d'impédances 3 et l'oscillateur VCO 4. Ce préamplificateur 9 est alimenté en courant i_Ina par une source de courant 8, qui peut faire partie du générateur de courant de polarisation ou être indépendante de ce générateur. Sur cette figure 3, il n'est pas représenté le détecteur d'oscillation et la boucle à verrouillage de phase PLL, mais comme auparavant, ils agissent à un même endroit du récepteur. L'oscillateur VCO 4 comprend exactement les mêmes éléments ou composants déjà décrits en référence à la figure 2. De ce fait ils ne seront pas répétés ici pour connaître leurs connexions l'un avec l'autre. La première inductance L1 et un condensateur C1 sont reliés en parallèle.

L'unité d'adaptation d'impédances 3 comprend un premier condensateur 31 relié d'un premier côté à la borne ou pad 2 d'entrée du récepteur 1, alors qu'un second côté du premier condensateur 31 est relié à une première extrémité d'une inductance additionnelle 33, une seconde extrémité de l'inductance additionnelle 33 est reliée à une entrée du préamplificateur 9. L'inductance additionnelle 33 est séparée en deux inductances liées l'une à l'autre et dont la liaison des deux parties d'inductance peut être reliée à une tension de polarisation Vbias. La liaison du premier condensateur 31 et de l'inductance additionnelle 33 est encore reliée à une seconde entrée du préamplificateur 9 et à un premier côté d'un quatrième condensateur 35 dont le second côté est relié à la masse. Un premier côté d'un cinquième condensateur 36 est relié à une seconde extrémité de l'inductance additionnelle 33. Le second côté du cinquième condensateur 36 est relié à la masse.

Le préamplificateur 9 est composé de deux paires de transistors NMOS disposées l'une au-dessus de l'autre. La première paire de transistors NMOS M5, M6 ont leurs sources reliées pour recevoir un courant i_Ina d'une source de courant 8 qui peut également faire partie du générateur de courant de polarisation. La grille du premier transistor M5 de la première paire est reliée à la seconde extrémité de l'inductance additionnelle 33 et au premier côté du cinquième condensateur 36. La grille du second transistor M6 de la première paire est reliée à la première extrémité de l'inductance additionnelle 33 et au premier côté du quatrième condensateur 35. Le drain du premier transistor M5 de la première paire est reliée à la source du premier transistor M3 de la seconde paire, alors que le drain du second transistor M6 de la première paire est relié à la source du second transistor M4 de la seconde paire. Les grilles des premier et second transistors M3 et M4 de la seconde paire sont reliées à une borne de tension d'alimentation Vdd. Le drain du premier transistor M3 de la seconde paire est relié à la première extrémité de connexion de l'inductance L1 et du condensateur C1. Finalement le drain du second transistor M4 de la seconde paire est relié à la seconde extrémité de connexion de l'inductance L1 et du condensateur C1. Le courant de polarisation fourni par le préamplificateur 9 permet de réduire le temps d'accroissement du courant de polarisation du générateur de courant de polarisation 7. Dans ces conditions, la valeur limite du courant critique arrive beaucoup plus vite ce qui réduit encore le temps d'enclenchement du récepteur.

Comme précédemment indiqué, il peut être utilisé un oscillateur de référence 4 autre qu'un oscillateur VCO traditionnel pour autant qu'il puisse fonctionner à haute fréquence par exemple vers 2,4 GHz.

A partir de la description qui vient d'être faite plusieurs variantes du procédé de détection d'un signal RF dans un récepteur à super réaction peuvent être imaginées sans sortir du cadre défini par les revendications.

## Revendications

1. Procédé de détection d'un signal RF capté par une borne ou pad (2) de réception d'un récepteur (1) à super réaction, le récepteur (1) comprenant un oscillateur de référence (4) pour la génération d'une oscillation dans l'oscillateur, un générateur de courant de polarisation (7) pour l'oscillateur de référence (4) pour fournir un courant de polarisation dès la réception d'un signal de commande de début d'oscillation (start), un détecteur d'oscillation (6) connecté entre une entrée ou une sortie (coilp) de l'oscillateur de référence (4) et le générateur de courant de polarisation (7) pour commander le générateur (7) quand un signal RF est reçu par le récepteur, et une unité d'adaptation d'impédances (3) disposée entre une borne ou pad (2) de réception du récepteur (1) et l'oscillateur de référence (4),
**caractérisé en ce que**, suite à l'activation d'un signal de commande de début d'oscillation (start), le procédé comprend l'étape de détecter l'oscillation de l'oscillateur de référence (4), et dès que l'oscillateur de référence oscille au-dessus d'une valeur critique de courant de polarisation croissant, le détecteur d'oscillation (6) commande le générateur de courant de polarisation (7) pour couper immédiatement le courant de polarisation (i_vco) de l'oscillateur de référence (4) et arrêter ainsi l'oscillation de l'oscillateur de référence (4), dans le but de réduire la consommation électrique générale lors de la phase de détection d'un signal RF.

2. Procédé de détection d'un signal RF selon la revendication 1, **caractérisé en ce que** le courant de polarisation (i_vco) est fourni à l'oscillateur de référence (4) notamment suite à la réception de chaque signal de commande de début (start) dans le temps d'un cycle de signaux de commande (Sosc) pour le générateur de courant de polarisation (7).

3. Procédé de détection d'un signal RF selon la revendication 2, **caractérisé en ce que** le signal de commande de début (start) démarre sur une période de 1 µs et que sur une seconde, on peut compter près de 1000 périodes de commande de début (start) d'un cycle de signaux de commande successifs (Sosc) de telle manière que le récepteur (1) n'est enclenché totalement que pendant 1 ms sur une seconde.

4. Procédé de détection d'un signal RF selon l'une des revendications précédentes, pour lequel le récepteur (1) comprend encore une boucle PLL à verrouillage de phase (5), **caractérisé en ce que** dans le temps, une tension d'adaptation (Vtune) est fournie à l'oscillateur de référence, qui est un oscillateur VCO (4) pour l'adaptation de la fréquence d'oscillation.

5. Procédé de détection d'un signal RF selon l'une des revendications précédentes, **caractérisé en ce qu'**à chaque signal de commande d'activation ou de début (start) fourni au générateur de courant de polarisation (7), un courant de polarisation augmente jusqu'à atteindre une valeur de courant critique à partir de laquelle l'oscillation de l'oscillateur de référence (4) débute, et **en ce que** le détecteur d'oscillation (6) détecte en entrée ou en sortie de l'oscillateur de référence (4) ladite oscillation pour fournir un signal de commande d'arrêt (stop) au générateur de courant de polarisation (7) de manière à couper immédiatement la fourniture d'un courant de polarisation à l'oscillateur de référence (4) pour l'arrêter immédiatement et ainsi réduire la consommation électrique du récepteur.

6. Récepteur à super réaction (1) pour la mise en œuvre du procédé de détection d'un signal RF selon l'une des revendications précédentes, **caractérisé en ce que** le récepteur comprend un oscillateur de référence (4) pour la génération d'une oscillation dans l'oscillateur, un générateur de courant de polarisation (7) pour l'oscillateur de référence (4) pour fournir un courant de polarisation (i_vco) dès la réception d'un signal de commande de début d'oscillation (start), un détecteur d'oscillation (6) connecté entre une entrée ou une sortie (coilp) de l'oscillateur de référence (4) et le générateur de courant de polarisation (7) pour commander le générateur (7) quand un signal RF est reçu par le récepteur, et une unité d'adaptation d'impédances (3) disposée entre une borne ou pad (2) de réception du récepteur (1) et l'oscillateur de référence (4), ledit détecteur d'oscillation (6) étant destiné à détecter une oscillation de l'oscillateur de référence et dès cet instant fournir un signal de commande au générateur courant de polarisation pour couper immédiatement le courant de polarisation de l'oscillateur de référence (4) et ainsi arrêter l'oscillation de l'oscillateur de référence pour réduire la consommation électrique.

7. Récepteur à super réaction (1) selon la revendication 6, **caractérisé en ce qu'**il comprend également une boucle PLL à verrouillage de phase (5) pour fournir une tension d'adaptation (Vtune) à l'oscillateur de référence qui est un oscillateur VCO (4).

8. Récepteur à super réaction (1) selon la revendication 6 **caractérisée en ce que** l'oscillateur de référence (4) fonctionne à une fréquence égale ou supérieure à 2,4 GHz et sans abaissement de fréquences pour des opérations de démodulation.
